# EUROPEAN PATENT SPECIFICATION

(11) **EP 2 710 631 B1**
(45) Date of publication and mention of the grant of the patent: **08.07.2020**
(21) Application number: 12717956.2
(22) Date of filing: 12.04.2012
(51) Int. Cl.: H01L 23/36, H01L 23/467, H01L 23/367, H01L 23/44, H05K 7/20

(54) **HEAT SINK FOR COOLING POWER ELECTRONICS**
KÜHLKÖRPER ZUR KÜHLUNG VON LEISTUNGSELEKTRONIK
DISSIPATEUR DE CHALEUR DESTINÉ À REFROIDIR UNE ÉLECTRONIQUE DE PUISSANCE

(30) Priority: 17.05.2011 US 201161487068 P
(43) Date of publication of application: 26.03.2014
(73) Proprietor: Carrier Corporation, Farmington, CT 06034 (US)
(72) Inventor: TARAS, Michael F., Fayetteville, New York 13066 (US); LEE, KeonWoo, Manlius, New York 13104 (US); PERKOVICH, Mark J., Fayetteville, New York 13066 (US); DURAISAMY, Suresh, Liverpool, New York 13090 (US); LIAO, XuQiang, Manlius, New York 13104 (US)
(74) Representative: Schmitt-Nilson Schraud Waibel Wohlfrom Patentanwälte Partnerschaft mbB
(86) International application number: PCT/US2012/033184
(87) International publication number: WO 2012/158289

(56) References cited:
- EP-A1- 0 757 220
- EP-A2- 1 858 077
- DE-U1-202007 017 501
- JP-A- 10 263 779
- JP-A- 2001 308 232
- US-A- 5 352 991
- US-A1- 2004 244 947
- US-A1- 2005 088 826
- US-A1- 2006 215 367
- US-B1- 6 180 436
- SAMUEL GRAFF & ARTHUR DAVID SNIDER: "Mathematical Analysis of the Length-of-Arc Assumption", HEAT TRANSFER ENGINEERING, HEMISPHERE PUB, WASHINGTON, DC, US, vol. 17, no. 2, 1 January 1996 (1996-01-01), pages 67-71, XP008151732, ISSN: 0145-7632, DOI: 10.1080/01457639608939874 [retrieved on 2007-04-27]
- JAKOB M ED - JAKOB M: "Passage", 1 January 1967 (1967-01-01), HEAT TRANSFER, WILEY, NEW YORK, USA, PAGE(S) 217 - 221, XP008151717, the whole document
- SCHMIDT E: "Die Waermeuebertragung durch Rippen", ZEITSCHRIFT DES VEREINES DEUTSCHER INGENIEURE, DEUTSCHER INGENIEUR VERLAG, DUSSELDORF, DE, vol. 70, no. 26/28, 26 June 1926 (1926-06-26), pages 885-889, XP008151740, ISSN: 0341-7255

## Description

### Cross-Reference to Related Application

Reference is made to and this application claims priority from and the benefit of U.S. Provisional Application Serial No. 61/487,068, filed May 17, 2011, and entitled HEAT SINK FOR COOLING POWER ELECTRONICS.

### Background of the Invention

This invention relates generally to cooling electronics components, for example isolated-gate bipolar transistors (IGBT), semiconductor devices, capacitors and other components of an electronic device, such as, for example a power electronics module of a variable speed drive.

Power electronic devices are commonly used for controlling and/or manipulating the characteristics, for example the frequency and/or the voltage, of the electric power being supplied to a variety of electrically powered devices. For example, variable speed drives are commonly used in connection with variable speed motors for controlling the speed of the motor. Variable speed motors are used in connection with compressors, water pumps, fans and other devices. For example, refrigerant vapor compressors, such as, but not limited to, scroll compressors, reciprocating compressors and screw compressors, to enable driving the compression mechanism of the compressor at various operating speeds. As the operating speed of the compression mechanism is decreased, the output capacity of the compressor is decreased, and conversely as the operating speed of the compressor is increased, the output capacity of the compressor is increased. The variable speed drive is operative to vary the frequency of the electric power supplied to drive motor of the compressor, thereby varying the operating speed of the motor, and consequently the operating speed and output capacity of the compressor.

In operation, adequate cooling the power electronics devices, such as but not limited to variable speed drives, must be ensured by removing heat generated by the power electronics so as to maintain the reliability and the functionally of the power electronics devices.

### Summary of the Invention

In an aspect, a heat sink device is provided that is useful for cooling a power electronics module at a temperature below a specified operating threshold temperature.

In an aspect, a heat sink device is provided that is useful for cooling the power electronics of a variable speed drive housed in a sealed enclosure through which a flow of cooling air is directed over and across the heat sink device.

A heat sink device for cooling a power electronics module includes a base platform having a first surface and a second surface on opposite sides of the base platform, a plurality of upright members extending outwardly from the first surface of the base platform and defining a cavity wherein the power electronics module is disposed in conductive heat exchange relationship with the first surface of the base platform, and a plurality of heat transfer fins extending outwardly from the second surface of the base platform and defining a plurality of cooling air flow channels. In an embodiment, the plurality of heat transfer fins may be disposed in parallel spaced relationship at a uniform spacing side-to-side. A fan may be disposed in operative association with the plurality of cooling air flow channels for passing a flow of cooling air through the plurality of cooling air flow channels in convective heat exchange relationship with the plurality of heat transfer fins. The ratio of the fin spacing to a thickness of a base portion of each fin of the plurality of heat transfer fins may be in the range from 2 to 3 inclusive. In an embodiment, the plurality of heat transfer fins may comprise flat plate fins having a uniform thickness. In an embodiment, the plurality of heat transfer fins may comprise a plurality of tapered fins, each tapered fin having a base portion and a tip portion with the base portion having a thickness greater then a thickness of the tip portion. The tapered fins may have the fin slope as measured from the fin centerline in the range from 1.0 to 1.5 degrees.

US 5 352 991 A discloses power amplifier assembly that dissipates a maximum of one thousand one hundred watts includes a power amplifier circuit and a chassis that has an overall volume of 0,02 cubic meters. The chassis includes a heat sink base that contains a mounting pattern for the power amplifier circuit. By thermally coupling the power amplifier circuit to the heat sink base via thermal coupling devices and the mounting pattern, the heat sink base dissipates a maximum of one thousand one hundred watts in a volume of 0,016 cubic meters.

According to EP 1 858 077 A2 an electronic package is provided for dissipating heat away from electronic devices. The package includes a substrate and electronic devices mounted on the substrate. The package also has a thermally conductive heat sink assembled over the electronic device. The heat sink includes compliant pedestals each having a contact surface for contacting a surface of an electronic device to conduct thermal energy away from the electronic device. The package is held together such that the heat sink is in contact with the surface of an electronic device such that each compliant pedestal applies a compressive force to the surface of the electronic device.

US 2004/244947 A1 discloses a heat sink including a base having a first side in contact with a heat-generating electronic element and a second side opposed to the first side. Fins are formed on the second side of the base. A non-rectilinear air channel is formed between two adjacent fins, with a length of the non-rectilinear air channel being greater than a length of the base along an extending direction of the fins on the base. The plurality of heat transfer fins may comprise fins of at least two different heights and/or fins of at least two different cross-sections.

US 2006/0215367 A1 discloses a thermal dissipation apparatus includes a primary heat sink. The primary heat sink includes a first base member including a component coupling surface and a secondary heat sink coupling surface, and a plurality of fins extending from the first base member. A secondary heat sink may be provided such that the primary heat sink is operable to provide thermal dissipation in a low profile form factor chassis while the secondary heat sink may be coupled with the primary heat sink to provide more optimal thermal dissipation in a high profile form factor chassis.

### Brief Description of the Drawings

For a further understanding of the disclosure, reference will be made to the following detailed description which is to be read in connection with the accompanying drawing, where:
FIG. 1 is a perspective view of an exemplary embodiment of a hest sink device as disclosed herein;
FIG. 2 is a cross-sectional elevation view of the exemplary embodiment of the heat sink device depicted in FIG. 1 taken along line 2-2 of FIG. 1;
FIG. 3 is a cross-sectional elevation view of another exemplary embodiment of the heat sink device disclosed herein showing a different configuration of heat transfer fins;
FIG. 4 is a plan view of the heat sink device depicted in FIG. 2 taken along line 4-4 of FIG. 2;
FIG. 5 is a perspective view of the heat sink device as disclosed herein housed in a cooling air duct;
FIG. 6 is a cross-sectional elevation view taken along line 6-6 of FIG. 5;
FIGs. 7A and 7B are side elevation views showing various dimensional parameters with respect to a uniform thickness heat transfer fin and a tapered heat transfer fin, respectively; and
FIGs. 8A, 8B, 8C and 8D are side elevation views showing various dimensional parameters with respect to fins, respectively, having bumps/risers, having fin cut-offs, having a wave-like configuration, and having an arcuate configuration.

### Detailed Description of the Invention

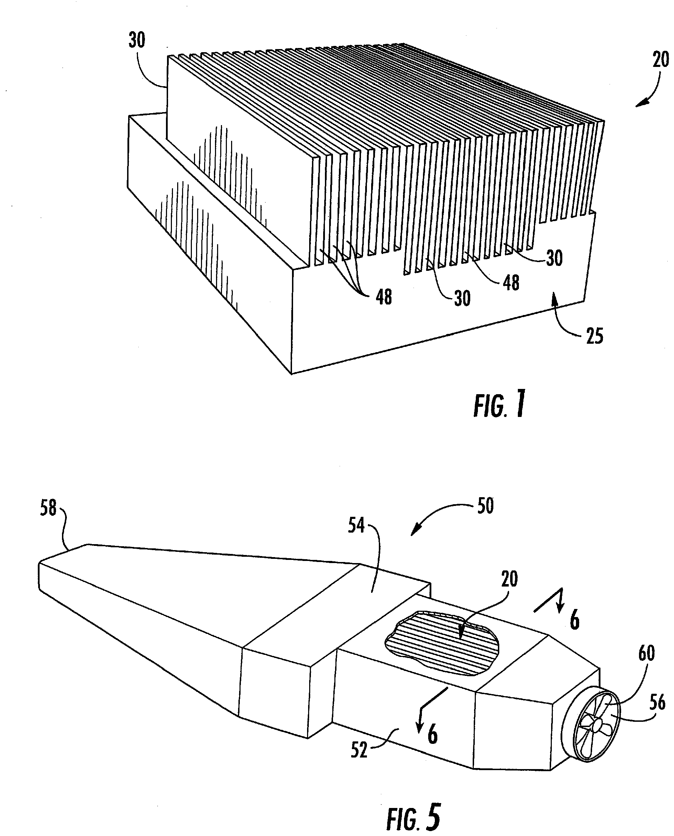

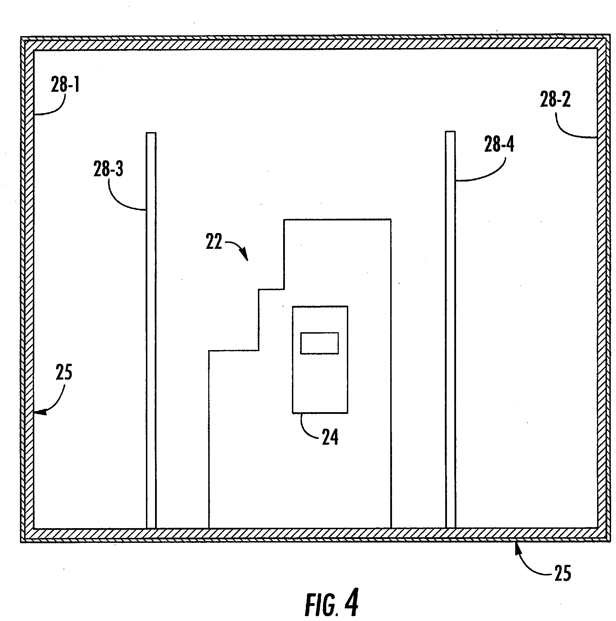

Referring initially to FIGs. 1 - 4, there are depicted exemplary embodiments of a heat sink device 20 for cooling electronics components, for example isolated-gate bipolar transistors, semiconductor devices, capacitors and other electronics components that generate heat during operation. The heat sink device 20 will be described herein in application for cooling a power electronics module 22 of a variable frequency drive. In the depicted embodiments, the power electronics module 22 includes an isolated-gate bipolar transistor (IGBT) 24 and may include other semiconductor devices (not shown), capacitors (not shown), or other heat generating components. Variable speed drives are used, for example, in connection with variable speed drive motors (not shown) for driving refrigerant vapor compressors, air moving devices and/or water pumps on refrigerant vapor compression systems of transport refrigeration units for controlling a temperature within the cargo box of a refrigerated container for shipping perishable cargo by sea, by road, by rail or intermodally.

The heat sink device 20 includes a base platform 26, a plurality of upright members 28, and a plurality of heat transfer fins 30. The base platform 26, the upright members 28 and the heat transfer fins 30 may be formed by extrusion, by casting, or by machining to form an integral one-piece heat sink device 20. The heat sink device 20 may be formed of aluminum, aluminum alloys, copper, copper alloys, or other materials having a high thermal conductivity.

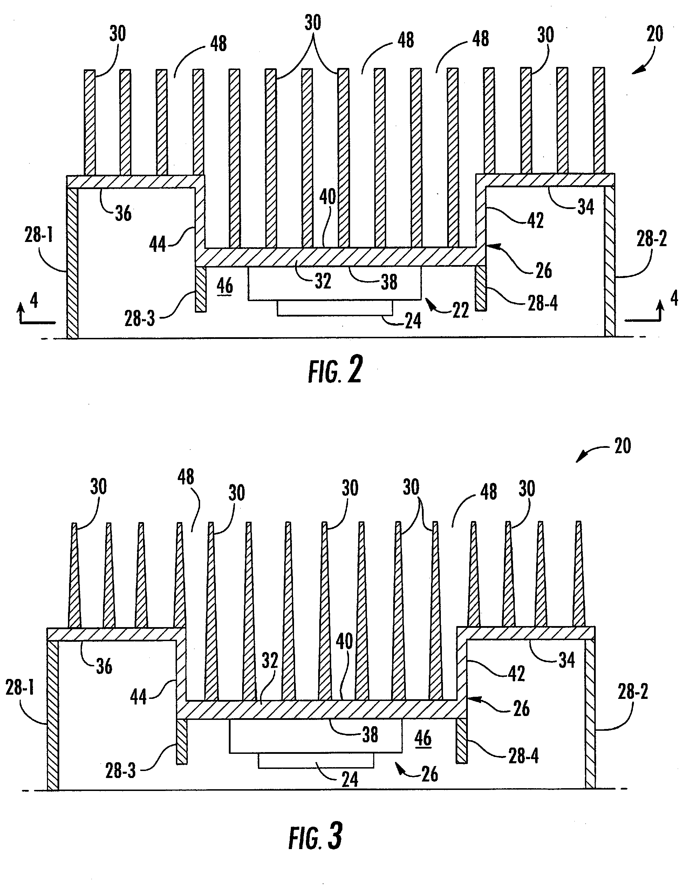

In the depicted embodiment, the base platform 26 has a middle span 32, a right-hand span 34 (to the right of the middle span 32 as viewed in FIGs. 2 and 3) and a left hand span 36 (to the left of the middle span 32 as viewed in FIGs. 2 and 3). Link member 42 connects the right-hand span 34 of the base platform 26 to the right end of the middle span 32 and link member 44 connects the left-hand span 36 of the base platform 26 to the left end of the middle span 36. In the depicted embodiments, the link member 42 extends perpendicularly to the right-hand span 34 and to the middle span 32 and the link member 44 extends perpendicularly to the left-hand span 36 and to the middle span 32. It is to be understood, however, that the base platform 26 may take other forms, including a flat plate, a plate having one or more recessed spans, a plate having one or more raised sections, a plate having a combination of one or more recessed spans and one or more raised sections.

The base platform 26 has a first surface 38 on one side thereof and a second surface 40 on the opposite side thereof. Upright members 28-1, 28-2, 28-3, 28-4 extend outwardly from the first surface 38 of the base platform 26, which in the embodiments depicted in FIGs. 2- 4 is on the lower side of the base platform 26. A cavity 46 is defined on the lower side of the base platform 26 bounded by the wall 25 formed by the outboard upright members 28-1 and 28-2 and the laterally extending upright members interconnecting members 28-1 and 28-3. The power electronics module 22 is housed within the cavity 46. In the depicted embodiment, the IGBT 24 is mounted in a central portion of the cavity 46 between the inboard uprights 2-3 and 28-4 and disposed in conductive heat transfer relationship with the middle span 32 of the base platform 26. Although not shown, it is to be understood that other heat generating components of the power electronics module may be disposed in the two side portions of the cavity 46 in conduction heat transfer relationship with the respective right-hand and left-hand spans 34, 36 of the base platform 26. Further, it is to be understood that the configuration of cavity 46 and the arrangement and type of the power electronics housed therein is exemplary and other arrangements are permissible.

Heat transfer fins 30 extend outwardly from the second surface 40 of the base platform 26, which in the embodiments depicted in FIGs 1-3 is on the upper side of the base platform 26. The plurality of heat transfer fins 30 extending outwardly from the base platform 26 of the heat sink device 20 may be arrayed in laterally spaced, parallel relationship and extend generally longitudinally along the second surface 40 of the base platform 26 to form a plurality of cooling air flow channels 48, including a cooling air flow channel 48 between each of the various sets of neighboring heat transfer fins 30. As will be discussed further hereinafter, a flow of cooling air may be passed through the channels 48 in heat exchange relationship with the heat transfer fins 30 to remove heat from the heat transfer fins 30. As the heat transfer fins 30 are disposed in conductive heat transfer relationship through the base platform 26 of the heat sink device 20 with the cavity 36 and the power electronics module 22 housed therein, heat generated by the power electronics module 22 is effectively transferred to and removed by the cooling air flow passing through the channels 48 without the cooling air flow directly contacting the power electronics module 22 housed within cavity 46.

In the embodiment depicted in FIG. 2, the heat transfer fins 30 comprise flat plate fins having a rectangular cross section profile of uniform thickness from base to tip. In the embodiment depicted in FIG. 3, the heat transfer fins 30 comprise flat plate fins having a tapered cross section profile of tapering thickness, being tapered inwardly from base to tip. In the uniform thickness embodiment for example, the heat transfer fins 30 may have a thickness in the range of from 3 to 4 millimeters (0.12 to 0.157 inches) and spaced side-to-side at spacing in the range of 10 to 11 millimeters (0.39 to 0.43 inches). In the uniform thickness embodiment, the base platform 26, the upright members 28 and heat transfer fins 30 may be formed by extrusion as an integral, one-piece heat sink device 20. In the tapered fin embodiment for example, the heat transfer fins may have a thickness at the fin base in the range of 3 to 4 millimeters (0.12 to 0.157 inches) and inwardly sloping sides having a slope greater than 1 degree and less than 1.5 degrees. In the tapered thickness fin embodiment, the base platform 26, the upright members 28 and heat transfer fins 30 may be formed by casting as an integral, one-piece heat sink device 20. Further, the fin density and fin parameters, such as cross-section thickness, height and form factor, may be selectively varied along the base platform 26 to provide the most optimal heat exchange pattern and temperature distribution across the longitudinal and lateral expanse of the base platform 26 to maintain the power electronics housed within the cavity 46 below the desired operational threshold temperature. For instance, higher fin density and increased cross-section thickness may be desired in the area surrounding the higher power generation electronics.

It is to be understood that in other embodiments, the heat transfer fins 40 may be curved plate fins or wave-like fins extending longitudinally in parallel spaced relationship. The heat transfer fins 30 may have a cross-section form that is rectangular or tapered, as shown in the depicted embodiments, but may instead have a cross-section form that is triangular, trapezoidal, hyperbolic, parabolic, elliptical or other desired cross-section shape. The heat transfer fins 30 may include heat transfer enhancements such as, but not limited to surface roughness, beads, surface bumps or risers, louvers, off-sets, and cut-offs between fins. Any combination of the abovementioned heat transfer enhancement features may be used on the heat sink device 20 disclosed herein.

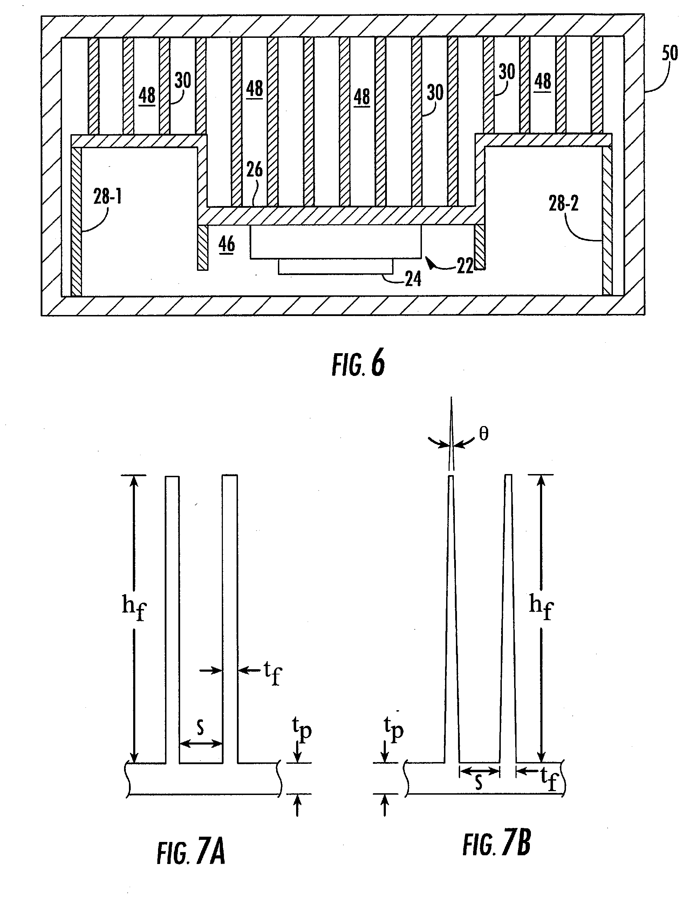

Referring now to FIGs. 5 and 6, the heat sink device 20 is shown disposed within a housing 50 defining a chamber 52 wherein the heat sink device 20 is disposed and also defining a cooling air flow duct 54. The housing 50 further includes a cooling air inlet opening 56 at a first end of the housing 50 and a cooling air outlet opening 58 at a second end of the housing 32 longitudinally opposite the first end of the housing 50. A cooling air fan 60 is provided in operative association with the housing 50 for passing cooling air through the flow duct 54. The cooling air fan 60 may be mounted in the cooling air inlet opening 56 for blowing cooling air through the flow duct 54 or may be mounted in the cooling air outlet opening 42 for drawing cooling air through the flow duct 54. In either arrangement, the cooling air fan 50 is operative to pass a flow of cooling air, typically, but not limited to, ambient air, through the channels 48 formed between the various sets of neighboring pairs of heat transfer fins 30.

When disposed within the housing 50, the tips of the heat transfer fins 30 are juxtaposed in substantially abutting relationship with one interior wall of the housing 50, while the end faces of the upright members forming the bounding wall 25 are juxtaposed in substantially abutting relationship with the opposite interior wall of the housing 50. The cooling air flow passes through the channels 48 across and over, and in convective heat exchange relationship with, the heat transfer surface of the heat transfer fins 30. In this manner, heat generated by the power electronics module 22 housed in the chamber 46 is removed by the cooling air flow by means of conductive heat exchange from the cavity 46 and the power electronics module 22 through the base platform 26 to the heat transfer fins 30 and by means of convective heat exchange from the heat transfer fins 30 to the cooling air flow passing through the channels 48. However, the power electronics module 22, being disposed in the cavity 46, remains isolated from the cooling air flow and therefore not exposed to moisture or corrosive elements that might be present in the cooling air flow.

In the depicted embodiment, the cooling air fan 60 is mounted in the cooling air inlet opening 56 and operates to blow ambient air into and through the cooling air flow duct 54 to pass across and over the surfaces of the heat transfer fins 30 and the base platform 26 of the heat sink device 20. To achieve sufficient convective heat transfer between the cooling air flow and the heat transfer fins 30 and the base platform 26 of the heat sink device 20 to ensure cooling of the power electronics module 24 to a temperature below a threshold temperature of 85°C (185°F) in accord with the method disclosed herein, the cooling air flow may be passed through the flow channel at an air flow velocity in the range of from 4 to 20 millimeters per second per Watt of heat rejection by the power electronics module 24.

By way of example, tests of a prototype of the heat sink device 20 housing a 300 Watt IGBT and disposed in a cooling air flow duct at or within a distance of one-half the width of the heat sink device downstream of the outlet of the cooling air fan 60. Additionally, the heat transfer fins 30 were tapered fins having a height of 45 millimeters (1.77 inches), a base width of 3 millimeters (0.118 inches) and a tip width of 1.43 millimeters (0.056 inches) on the right-hand and left-hand sections 34, 36 of the base platform 26 and having a height of 70 millimeters (2.76 inches), a base width of 4 millimeters (0.157 inches) and a tip width of 0.56 millimeters (0.022 inches) on the middle section 32 of the base platform 26. The base platform 26 of the tested heat sink device 20 had a thickness of 8 millimeters (0.315 inches) in the middle section 32 and a thickness of 4 millimeters (0.157 inches) in each of the right-hand side and left-hand side sections 34, 36 of the base platform 26. The heat sink device was cast as an integral one-piece heat sink device 20 using an AlSi12 aluminum silicon alloy. The temperature of the 300 W IGBT was maintained below a threshold maximum temperature of 85°C (185°F) using a cooling air flow having at inlet temperature of 39°C (100°F) passing through the cooling air flow channels at an air flow velocity of in the range of at least 3.0 meters/second (9.8 feet per second) to 8.0 meters per second (26 feet per second) at a fan output cooling air flow rate in the range from 70 to 90 CFM (cubic feet per minute) (2.0 to 2.5 cubic meters per minute).

Various specific non-dimensional geometric ratios have been identified and quantified for facilitating manufacturing and enhancing heat transfer performance of the heat sink device 20 disclosed herein, while achieving a reduction in footprint area, a reduction in material content, and a reduction in cost. The various dimensional parameters referred to in the following paragraphs are shown in FIG. 7A with respect to a heat transfer fin having uniform thickness and in FIG. 7B with respect to a tapered heat transfer fin.

The ratio of the height of the heat transfer fins 30 to the thickness of the base platform 26 from which the fins 30 extend should lie in the range of 2 to 30, inclusive, to facilitate manufacturing.

The ratio of the thickness tₚ of the base platform 26 from which the fins 30 extend to the nominal fin thickness, which for a fin having a uniform thickness t_{f} and for a fin having a non-uniform thickness is an average thickness (t_{b} - tₜ)/2, should be in the range from 0.5 to 1.0, inclusive, to ensure adequate conductive heat transfer between the fins 30 and the base platform 26.

For tapered fins, the ratio of the difference between the thickness of the fin base and the thickness of the fin tip (t_{b} - tₜ) to the fin height h_{f} should be such as to provide a fin slope Ø, as measured from the fin centerline, in the range from 1.0 to 1.5 degrees, inclusive, to facilitate casting of the heat sink device 20.

The ratio of the spacing S between the side walls of neighboring fins 30 at the base of the fins to the thickness of the fins t_{b} at the fin base should be in the range from 2 to 3, inclusive, to facilitate manufacturing.

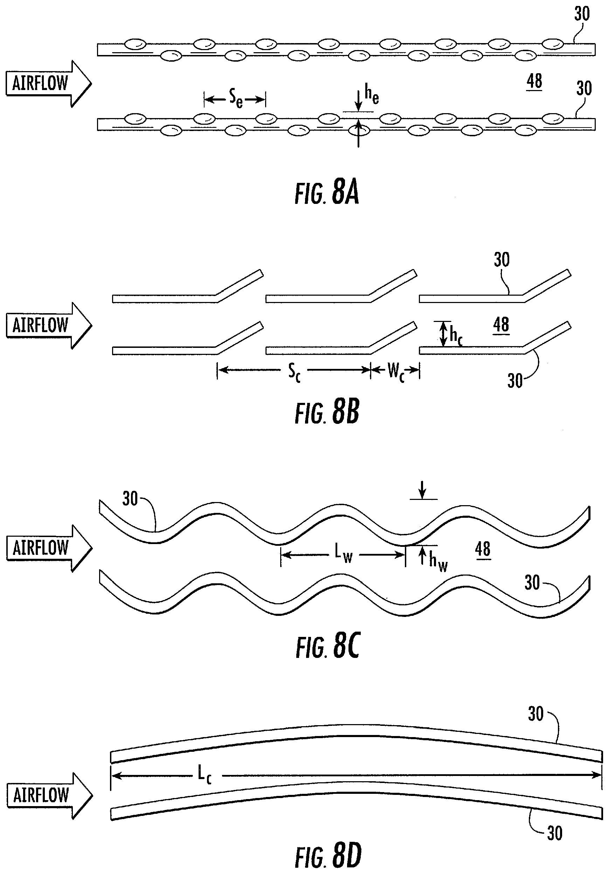

As noted previously, the heat transfer fins 30 may include heat transfer enhancements such as surface roughness, surface bumps, which includes risers, and fin cutoffs. With respect to surface roughness, the surface roughness enhancement may have a height in the range of 0.38 to 1.52 millimeters (0.015 to 0.06 inches). With respect to fins 30 having surface bumps or risers, see FIG. 8A, the ratio of enhancement height hₑ to enhancement spacing Sₑ may have a value in the range of 0.01 to 0.10 and more narrowly in the range of 0.02 to 0.05. With respect to fins 30 having fin cutoffs, see FIG. 8B, the ratio of the cutoff width w_{c} to the spacing S_{c} between cutoffs may have a value in the range of 0.25 to 0.75, and more narrowly in the range of 0.4 to 0.6, and the ratio of the cutoff height h_{c} to fin spacing may have a value in the range of 0.1 to 0.5.

For wave-like heat transfer fins, see FIG. 8C, the ratio of wave height h_{w} to wave length l_{w} may have a value in the range of 0.06 to 0.56, and more narrowly in the range of 0.12 to 0.28. The heat transfer fins may be arcuate in longitudinal expanse having a nominal curvature radius and a curvature length. For example, in an embodiment, the arcuate fins may have a curvature that has an upwardly convex profile in the vertical so that water/condensate would drain off rather than collect in the curve of the arcuate fin. For such a curved fin, see FIG. 8D, the ratio of the nominal curvature radius of the fin to the channel length L_{c} of the fin may have a value in the range of 0.5 to 3, and more narrowly in the range of 0.8 to 1.5.

With the heat sink device 20 as disclosed herein, heat may be removed from the cavity 36 and the power electronics module 24 disclosed within the cavity 36 through primarily conductive heat exchange to the base platform 26 and therethrough to the heat transfer fins 30 and thence by primary convective heat exchange trough the heat transfer fins 30 to the cooling air flow passing through the channels 48 of the heat sink device 20. In this manner, the power electronics module 24 may be cooled without being in direct contact with the cooling air. Thus, the power electronics module 24 will not be exposed to moisture or corrosive elements within the cooling air, typically ambient air, and the potential corrosive effects attendant with such exposure.

## Claims

1. A heat sink device (20) for cooling a power electronics module (22) comprising:
a base platform (26) having a first surface (38) and a second surface (40) on opposite sides of the base platform (26);
a plurality of upright members (28) extending outwardly from the first surface (38) of the base platform (26) and defining a cavity (46) wherein the power electronics module (22) is disposed in conductive heat exchange relationship with the first surface (38) of the base platform (26);
a plurality of heat transfer fins (30) extending outwardly from the second surface (40) of the base platform (26) and defining a plurality of cooling air flow channels (48)
**characterized in that** the heat sink device (20) is disposed in a housing (50) defining a chamber (52) such that the tips of the heat transfer fins (30) are juxtaposed in abutting relationship with a first interior wall of the housing (50), while the end faces of the upright members (28) are juxtaposed in abutting relationship with an opposite second interior wall of the housing (50).

2. The heat sink device (20) as recited in claim 1 further including a fan (50) disposed in operative association with the plurality of cooling air flow channels (48) for passing a cooling air flow through the plurality of cooling air flow channels (48) in convective heat exchange relationship with the plurality of heat transfer fins (30).

3. The heat sink device (20) as recited in claim 1 wherein the plurality of heat transfer fins (30) are disposed in parallel spaced relationship at a uniform spacing side-to-side, wherein the ratio of the fin spacing to a thickness of a base portion of each fin (30) of the plurality of heat transfer fins (30) is in particular in the range from 2 to 3 inclusive.

4. The heat sink device (20) as recited in claim 1 wherein the plurality of heat transfer fins (30) comprise flat plate fins (30) having a uniform thickness.

5. The heat sink assembly as recited in claim 1 wherein the plurality of heat transfer fins (30) comprise a plurality of tapered fins (30), each tapered fin (30) a base portion and a tip portion, the base portion having a thickness greater then a thickness of the tip portion, wherein the fin slope as measured from the fin centerline is in particular in the range from 1.0 to 1.5 degrees.

6. The heat sink device (20) as recited in claim 1 wherein the base platform (26) has a right span (34), a middle span (32) and a left span (36), the right span (34) and the left span (36) being connected to the opposite respective ends of the middle span (32).

7. The heat sink device (20) as recited in claim 6 wherein the middle span (32) of the base platform (26) has a first thickness, the right span (34) has a second thickness and the left span (36) has a third thickness.

8. The heat sink device (20) as recited in claim 7 wherein each fin (30) of the plurality of fins (30) has a fin base at the base platform (26) having at thickness and the ratio of the base thickness of each fin to the thickness of the respective span of the base platform (26) from which the fin extends is in the range of 0.5 to 1.0 inclusive, or wherein each fin (30) of the plurality of fins (30) has a fin height and the ratio of the fin height to the thickness of the respective span of the base platform (26) from which the fin extends in the range of 2 to 30 inclusive, or wherein the first thickness of the middle span (32) is in the range of 8 to 10 millimeters and each of the second thickness of right span (34) and the third thickness of the left span (36) is the range of 4 to 8 millimeters.

9. The heat sink device (20) as recited in claim 1 wherein the heat transfer fins (30) are disposed at a non-uniform fin density.

10. The heat sink device (20) as recited in claim 1 wherein each of the plurality of fins (30) has a cross-section profile selected from the group of cross-section profiles including rectangular, tapered, triangular, trapezoidal, hyperbolic, parabolic and elliptical.

11. The heat sink device (20) as recited in claim 1 wherein the plurality of fins (30) comprises wave-like plate fins (30), each wave-like plate fin having a wave height and a wave length, and a ratio of the wave height to wave length having a value in the range of 0.3 to 0.8.

12. The heat sink device (20) as recited in claim 1 wherein the plurality of fins (30) comprises at least one fin (30) having a heat transfer enhancement in the form of a plurality of surface roughness enhancements having an enhancement height up to 0.060 inches, or wherein the plurality of fins (30) comprises at least one fin having a heat transfer enhancement in the form of a plurality of raised bumps having an enhancement height and disposed in spaced relation on a fin heat exchange surface at an enhancement spacing, a ratio of the enhancement height to the enhancement spacing having a value in the range of 0.01 to 0.10.

13. The heat sink device (20) as recited in claim 1 wherein the plurality of fins (30) comprises a plurality of fins (30) having at least one fin cutoff, the fin cutoff having a ratio of a cutoff width to a cutoff spacing in the range of 0.25 to 0.75 and a ratio of a cutoff height to a cutoff spacing in the range of 0.1 to 0.5.

14. The heat sink device (20) as recited in claim 1 wherein the plurality of fins (30) comprises a plurality of arcuate fins (30) having an upwardly convex curvature in a vertical plane, wherein the plurality of arcuate fins (30) in particular have a curvature having a nominal curvature radius and a curvature length, a ratio of the nominal curvature radius to the curvature length having in particular a value in the range of 0.5 to 3.0.

15. The heat sink device (20) as recited in claim 1 wherein the plurality of heat transfer fins (30) comprises fins (30) of at least two different heights,or wherein the plurality of heat transfer fins (30) comprises fins of at least two different cross-sections.

## Patentansprüche

1. Kühlkörpervorrichtung (20) zur Kühlung eines Leistungselektronikmoduls (22), die Folgendes umfasst:
eine Basisplattform (26) mit einer ersten Fläche (38) und einer zweiten Fläche (40) an gegenüberliegenden Seiten der Basisplattform (26);
eine Vielzahl von aufrechten Elementen (28), die sich von der ersten Fläche (38) der Basisplattform (26) nach außen erstrecken und einen Hohlraum (46) definieren, wobei das Leistungselektronikmodul (22) in einer Wärmeleitung-Austauschbeziehung mit der ersten Fläche (38) der Basisplattform (26) steht;
eine Vielzahl von Wärmeübertragungsrippen (30), die sich von der zweiten Fläche (40) der Basisplattform (26) nach außen erstrecken und eine Vielzahl von Strömungskanälen (48) für Kühlungsluft definieren;
**dadurch gekennzeichnet, dass** die Kühlkörpervorrichtung (20) in einem Gehäuse (50) angeordnet ist, das eine Kammer (52) definiert, sodass die Spitzen der Wärmeübertragungsrippen (30) einer ersten Innenwand des Gehäuses (50) in einer anliegenden Beziehung gegenübergestellt sind, während die Endseiten der aufrechten Elemente (28) einer gegenüberliegenden zweiten Innenwand des Gehäuses (50) in einer anliegenden Beziehung gegenübergestellt sind.

2. Kühlkörpervorrichtung (20) nach Anspruch 1, die ferner einen Lüfter (50) beinhaltet, der in funktioneller Verknüpfung mit der Vielzahl von Strömungskanälen (48) für Kühlluft steht, um eine Kühlluftströmung durch die Vielzahl von Strömungskanälen (48) für Kühlluft strömen zu lassen, die in Wärmeleitung-Austauschbeziehung mit der Vielzahl von Wärmeübertragungsrippen (30) stehen.

3. Kühlkörpervorrichtung (20) nach Anspruch 1, wobei die Vielzahl von Wärmeübertragungsrippen (30) in einer parallel beabstandeten Beziehung in einer gleichförmigen Beabstandung Seite an Seite angeordnet sind, wobei das Verhältnis der Rippenbeabstandung zu einer Dicke eines Basisabschnitts jeder Rippe (30) der Vielzahl von Wärmeübertragungsrippen (30) insbesondere im Bereich von einschließlich 2 bis 3 liegt.

4. Kühlkörpervorrichtung (20) nach Anspruch 1, wobei die Vielzahl von Wärmeübertagungsrippen (30) flache Plattenrippen (30) umfasst, die eine gleichförmige Dicke aufweisen.

5. Kühlkörpervorrichtung nach Anspruch 1, wobei die Vielzahl von Wärmeübertragungsrippen (30) eine Vielzahl konischer Rippen (30) umfasst, wobei jede konische Rippe (30) einen Basisabschnitt und einen Spitzenabschnitt aufweist, wobei der Basisabschnitt eine Dicke aufweist, die größer als eine Dicke des Spitzenabschnitts ist und wobei die Neigung der Rippe, gemessen von der Mittellinie der Rippe, insbesondere im Bereich von 1,0 bis 1,5 Grad liegt.

6. Kühlkörpervorrichtung (20) nach Anspruch 1, wobei die Basisplattform (26) einen rechten Bereich (34), einen mittleren Bereich (32) und einen linken Bereich (36) aufweist, wobei der rechte Bereich (34) und der linke Bereich(36) mit den jeweiligen gegenüberliegenden Enden des mittleren Bereichs (32) verbunden sind.

7. Kühlkörpervorrichtung (20) nach Anspruch 6, wobei der mittlere Bereich (32) der Basisplattform (26) eine erste Dicke aufweist, der rechte Bereich (34) eine zweite Dicke aufweist und der linke Bereich (36) eine dritte Dicke aufweist.

8. Kühlkörpervorrichtung (20) nach Anspruch 7, wobei jede Rippe (30) der Vielzahl von Rippen (30) eine Rippenbasis an der Basisplattform (26) aufweist, die eine Dicke hat, wobei das Verhältnis jeder Basisdicke jeder Rippe zu der Dicke des jeweiligen Bereichs der Basisplattform (26), von welchem sich die Rippe erstreckt, im Bereich von einschließlich 0,5 bis 1,0 liegt, oder wobei jede Rippe (30) der Vielzahl von Rippen (30) eine Rippenhöhe aufweist und das Verhältnis der Rippenhöhe zu der Dicke des jeweiligen Bereichs der Basisplattform (26), von welcher sich die Rippe erstreckt, im Bereich von einschließlich 2 bis 30 liegt, oder wobei die erste Dicke des mittleren Bereichs (32) im Bereich von 8 bis 10 Millimeter liegt und sowohl die zweite Dicke des rechten Bereichs (34) als auch die dritte Dicke des linken Bereichs (36) im Bereich von 4 bis 8 Millimeter liegen.

9. Kühlkörpervorrichtung (20) nach Anspruch 1 wobei die Wärmeübertragungsrippen (30) in einer nicht gleichförmigen Rippendichte angeordnet sind.

10. Kühlkörpervorrichtung (20) nach Anspruch 1 wobei jede der Vielzahl von Rippen (30) ein Querschnittsprofil aufweist, das aus der Gruppe von Querschnittsprofilen ausgewählt ist, die rechteckige, konische, dreieckige, trapezförmige, hyperbelförmige, parabelförmige und elliptische beinhaltet.

11. Kühlkörpervorrichtung (20) nach Anspruch 1, wobei die Vielzahl von Rippen (30) wellenähnliche Plattenrippen (30) umfasst, wobei jede wellenähnliche Plattenrippe eine Wellenhöhe und eine Wellenlänge aufweist, und wobei ein Verhältnis der Wellenhöhe zu der Wellenlänge einen Wert in dem Bereich von 0,3 bis 0,8 hat.

12. Kühlkörpervorrichtung (20) nach Anspruch 1, wobei die Vielzahl von Rippen (30) mindestens eine Rippe (30) umfasst, die eine Wärmeübertragungsverstärkung in der Form einer Vielzahl von Verstärkungen der Oberflächenrauhheit mit einer Höhe der Verstärkung von bis zu 0,060 Zoll aufweist, oder wobei die Vielzahl von Rippen (30) mindestens eine Rippe umfasst, die eine Wärmeübertragungsverstärkung in der Form einer Vielzahl von erhöhten Erhebungen aufweist, die eine Verstärkungshöhe haben und in beabstandeter Beziehung an einer Wärmeaustauschfläche der Rippe in einem Verstärkungsabstand angeordnet sind, wobei ein Verhältnis der Verstärkungshöhe zu dem Verstärkungabstand einen Wert im Bereich von 0,01 bis 0,10 hat.

13. Kühlkörpervorrichtung (20) nach Anspruch 1, wobei die Vielzahl von Rippen (30) eine Vielzahl von Rippen (30) umfasst, die mindestens eine Rippenaussparung aufweisen, wobei die Rippenaussparung ein Verhältnis einer Breite der Aussparung zu einem Abstand der Aussparung im Bereich von 0,25 bis 0,75 und ein Verhältnis einer Höhe der Aussparung zu einem Abstand der Aussparung in dem Bereich von 0,1 bis 0,5 aufweist.

14. Kühlkörpervorrichtung (20) nach Anspruch 1, wobei die Vielzahl von Rippen (30) eine Vielzahl von bogenförmigen Rippen (30) umfasst, die eine in einer vertikalen Ebene nach oben konvexe Krümmung aufweisen, wobei die Vielzahl von bogenförmigen Rippen (30) insbesondere eine Krümmung mit einem nominalen Krümmungsradius und einer Krümmungslänge aufweisen, wobei ein Verhältnis des nominalen Krümmungsradius zu der Krümmungslänge insbesondere einen Wert im Bereich von 0,5 bis 3,0 hat.

15. Kühlkörpervorrichtung (20) nach Anspruch 1, wobei die Vielzahl von Wärmeübertagungsrippen (30) Rippen (30) mit mindestens zwei unterschiedlichen Höhen umfasst oder wobei die Vielzahl von Wärmeübertragungsrippen (30) Rippen mit mindestens zwei unterschiedlichen Querschnitten umfasst.

## Revendications

1. Dispositif dissipateur de chaleur (20) destiné à refroidir un module d'électronique de puissance (22) comprenant :
une plate-forme de base (26) ayant une première surface (38) et une seconde surface (40) sur les côtés opposés de la plate-forme de base (26) ;
une pluralité d'éléments verticaux (28) s'étendant vers l'extérieur depuis la première surface (38) de la plate-forme de base (26) et définissant une cavité (46) dans lequel le module d' électronique de puissance (22) est disposé en relation d'échange de chaleur par conduction avec la première surface (38) de la plate-forme de base (26) ;
une pluralité d'ailettes de transfert de chaleur (30) s'étendant vers l'extérieur depuis la seconde surface (40) de la plate-forme de base (26) et définissant une pluralité de canaux d'écoulement d'air de refroidissement (48)
**caractérisé en ce que** le dispositif dissipateur de chaleur (20) est disposé dans un boîtier (50) définissant une chambre (52) de sorte que les extrémités des ailettes de transfert de chaleur (30) sont juxtaposées en relation de butée avec une première paroi intérieure du boîtier (50), tandis que les faces d'extrémité des éléments verticaux (28) sont juxtaposées en relation de butée avec une seconde paroi intérieure opposée du boîtier (50).

2. Dispositif dissipateur de chaleur (20) selon la revendication 1, comportant en outre un ventilateur (50) disposé en association opérationnelle avec la pluralité de canaux d'écoulement d'air de refroidissement (48) pour faire passer un écoulement d'air de refroidissement à travers la pluralité de canaux d'écoulement d'air de refroidissement (48) en relation d'échange de chaleur par convection avec la pluralité d'ailettes de transfert de chaleur (30) .

3. Dispositif dissipateur de chaleur (20) selon la revendication 1, dans lequel la pluralité d' ailettes de transfert de chaleur (30) sont disposées dans une relation d' espacement parallèle au niveau d'un espacement uniforme d'un côté à l'autre, dans lequel le rapport de l'espacement des ailettes à une épaisseur d'une partie de base de chaque ailette (30) de la pluralité d'ailettes de transfert de chaleur (30) est en particulier compris dans la plage de 2 à 3 inclus.

4. Dispositif dissipateur de chaleur (20) selon la revendication 1, dans lequel la pluralité d'ailettes de transfert de chaleur (30) comprennent des ailettes de plaque minces (30) ayant une épaisseur uniforme.

5. Ensemble dissipateur de chaleur selon la revendication 1, dans lequel la pluralité d'ailettes de transfert de chaleur (30) comprennent une pluralité d'ailettes effilées (30), chaque ailette effilée (30) comprenant une partie de base et une partie d'extrémité, la partie de base ayant une épaisseur supérieure puis une épaisseur de la partie d'extrémité, dans lequel la pente de l'ailette mesurée depuis la ligne médiane de l'ailette est en particulier comprise dans la plage de 1,0 à 1,5 degré.

6. Dispositif dissipateur de chaleur (20) selon la revendication 1, dans lequel la plate-forme de base (26) a une portée droite (34), une portée médiane (32) et une portée gauche (36), la portée droite (34) et la portée gauche (36) étant reliées aux extrémités respectives opposées de la portée médiane (32).

7. Dispositif dissipateur de chaleur (20) selon la revendication 6, dans lequel la portée médiane (32) de la plate-forme de base (26) a une première épaisseur, la portée droite (34) a une deuxième épaisseur et la portée gauche (36) a une troisième épaisseur.

8. Dispositif dissipateur de chaleur (20) selon la revendication 7, dans lequel chaque ailette (30) de la pluralité d'ailettes (30) a une base d'ailette au niveau de la plate-forme de base (26) ayant une épaisseur et le rapport de l'épaisseur de base de chaque l'ailette à l'épaisseur de la portée respective de la plate-forme de base (26) depuis laquelle l'ailette s'étend est compris dans la plage de 0,5 à 1,0 inclus, ou dans lequel chaque ailette (30) de la pluralité d'ailettes (30) a une hauteur d'ailette et le rapport de la hauteur d'ailette à l'épaisseur de la portée respective de la plate-forme de base (26) depuis laquelle l' ailette s'étend est compris dans la plage de 2 à 30 inclus, ou dans lequel la première épaisseur de la portée médiane (32) est comprise dans la plage de 8 à 10 millimètres et chacune de la deuxième épaisseur de la portée droite (34) et de la troisième épaisseur de la portée gauche (36) est comprise dans la plage de 4 à 8 millimètres.

9. Dispositif dissipateur de chaleur (20) selon la revendication 1, dans lequel les ailettes de transfert de chaleur (30) sont disposées à une densité d'ailettes non uniforme.

10. Dispositif dissipateur de chaleur (20) selon la revendication 1, dans lequel chacune de la pluralité d'ailettes (30) a un profil de section transversale choisi dans le groupe de profils de section transversale comportant les profils rectangulaire, conique, triangulaire, trapézoïdal, hyperbolique, parabolique et elliptique.

11. Dispositif dissipateur de chaleur (20) selon la revendication 1, dans lequel la pluralité d'ailettes (30) comprend des ailettes de plaque en forme de vague (30), chaque ailette de plaque en forme de vague ayant une hauteur de vague et une longueur de vague, et un rapport de la hauteur de vague à la longueur de vague ayant une valeur comprise dans la plage de 0,3 à 0,8.

12. Dispositif dissipateur de chaleur (20) selon la revendication 1, dans lequel la pluralité d'ailettes (30) comprend au moins une ailette (30) ayant une amélioration de transfert de chaleur sous la forme d'une pluralité d'améliorations de rugosité de surface ayant une hauteur d'amélioration jusqu'à 0,060 pouces, ou dans lequel la pluralité d'ailettes (30) comprend au moins une ailette ayant une amélioration de transfert de chaleur sous la forme d'une pluralité de bosses surélevées ayant une hauteur d'amélioration et disposées en relation espacée sur une surface d'échange de chaleur d'ailette au niveau d'un espacement d'amélioration, un rapport de la hauteur d' amélioration à 1' espacement d' amélioration ayant une valeur comprise dans la plage de 0,01 à 0,10.

13. Dispositif dissipateur de chaleur (20) selon la revendication 1, dans lequel la pluralité d'ailettes (30) comprend une pluralité d'ailettes (30) ayant au moins une découpe d'ailette, la découpe d' ailette ayant un rapport d'une largeur de découpe à un espacement de découpe compris dans la plage de 0,25 à 0,75 et un rapport d'une hauteur de découpe à un espacement de découpe compris dans la plage de 0,1 à 0,5.

14. Dispositif dissipateur de chaleur (20) selon la revendication 1, dans lequel la pluralité d'ailettes (30) comprend une pluralité d'ailettes arquées (30) ayant une courbure convexe vers le haut dans un plan vertical, dans lequel la pluralité d'ailettes arquées (30) ont en particulier une courbure ayant un rayon de courbure nominal et une longueur de courbure, un rapport du rayon de courbure nominal à la longueur de courbure ayant en particulier une valeur comprise dans la plage de 0,5 à 3,0.

15. Dispositif dissipateur de chaleur (20) selon la revendication 1, dans lequel la pluralité d'ailettes de transfert de chaleur (30) comprend des ailettes (30) d'au moins deux hauteurs différentes, ou dans lequel la pluralité d'ailettes de transfert de chaleur (30) comprend des ailettes d'au moins deux sections transversales différentes.
